# FASCICULE DE BREVET EUROPEEN

(11) **EP 1 662 511 B1**
(45) Date de publication et mention de la délivrance du brevet: **10.03.2010**
(21) Numéro de dépôt: 05292538.5
(22) Date de dépôt: 30.11.2005
(51) Int. Cl.: G11C 29/02

(54) **Test d'un décodeur d'adresses de mémoire non volatile**
Test eines Adressdecoders mit nicht flüchtigem Speicher
Test of a decoder of non-volatile memory addresses

(30) Priorité: 30.11.2004 FR 0412705
(43) Date de publication de la demande: 31.05.2006
(73) Titulaire: STMicroelectronics SA, 92120 Montrouge (FR)
(72) Inventeur: Demange, Nicolas, 83470 Saint-Maximin (FR)
(74) Mandataire: Bentz, Jean-Paul

(56) Documents cités:
- US-A- 5 214 604
- US-A1- 2004 188 716

## Description

L'invention porte sur les mémoires non volatiles, telles que les EEPROM, et en particulier sur les tests d'erreurs réalisés sur les décodeurs de telles mémoires.

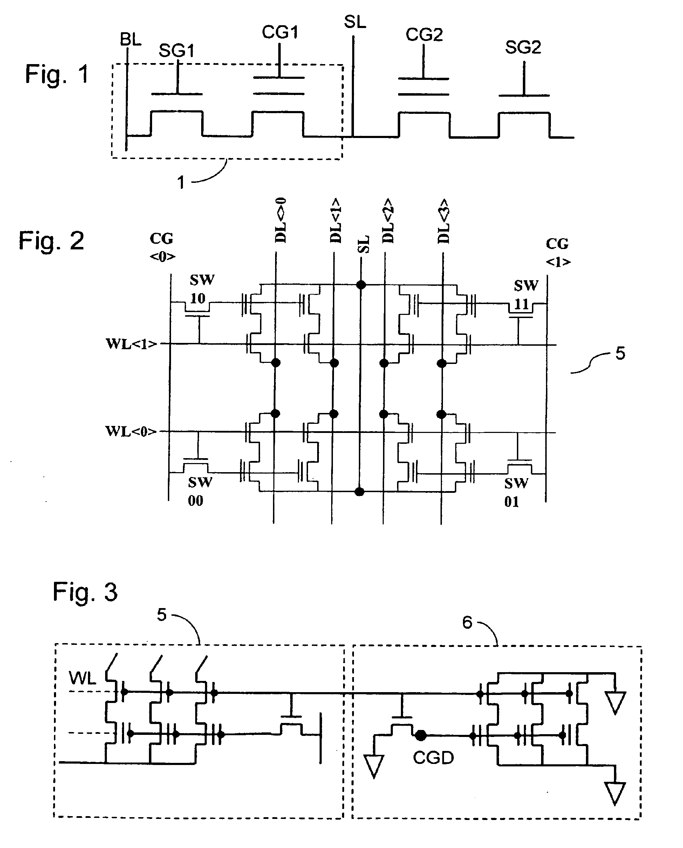

La figure 1 illustre une paire de cellules d'une mémoire EEPROM selon l'art antérieur. La cellule 1 est constituée d'un transistor de sélection SG1 et d'un transistor à grille flottante CG1. Le transistor SG1 est destiné à bloquer sélectivement l'accès au transistor CG1. Le transistor CG1 est destiné à la mémorisation et la lecture de données. Une seconde cellule est constituée des transistors SG2 et CG2 de façon similaire.

La figure 2 illustre de telles cellules disposées dans un plan mémoire 5. Ce plan mémoire présente 2 lignes de 2 mots de 2 bits. Chaque colonne du plan mémoire présente une ligne CG<i> connectée à un décodeur de colonnes. Le signal de la ligne CG<i> est sélectivement reproduit sur les grilles des transistors à grille flottante d'un mot par l'intermédiaire d'un transistor associé SW. Chaque transistor SW est rendu passant par l'activation d'une ligne de mot WL, connectée à un décodeur de lignes de mot. Les lignes DL<i> sont connectées à un décodeur de lignes de données.

Ces décodeurs sont sujets à différents types de dysfonctionnements en sortie des lignes de fabrication. Pour une adresse fournie à un décodeur, celui-ci peut activer deux lignes ou colonnes simultanément, aucune ligne ou colonne ou peut encore activer une ligne ou colonne non souhaitée. Des tests sont ainsi mis en oeuvre en fin de cycle de fabrication, afin de détecter les mémoires présentant des décodeurs défaillants.

Pour tester le fonctionnement de ces décodeurs, différents type de tests sont connus. Il est notamment connu d'utiliser un testeur externe à la mémoire EEPROM (ATE), de concevoir la mémoire en vue de sa testabilité (DFT) ou d'utiliser des circuits d'auto-test intégrés dans la mémoire (BIST). Des exemples de test sont le test de la diagonale ou le test dit « Checkerboard ».

Pour le test de la diagonale, une technique consiste à programmer les mots de données de la diagonale du plan mémoire, puis à lire le contenu de ces mots pour déterminer si l'adressage est correct. Comme la programmation ne peut être effectuée que ligne par ligne, le temps de test est conséquent et implique un surcoût de fabrication de la mémoire non négligeable. Par exemple, pour une mémoire EEPROM de 32KB présentant 512 lignes, le temps de programmation sera typiquement de 1 seconde, puis le temps de lecture sera de 250 ms.

Les fabricants déterminent classiquement le coût du temps de test en termes de surfaces de silicium. Par exemple, pour une mémoire en technologie 0,18µm, une seconde de test équivaut à 0,02mm². Des circuits de test destinés à réduire le temps de test ne doivent donc pas occuper une surface supérieure à la surface équivalent au temps qu'ils permettent de gagner.

Le document WO03-003379 décrit une mémoire EEPROM munie de circuits d'auto-tests, destinés à éliminer l'étape de programmation de la phase de test. Pour cela des cellules annexes sont couplées aux lignes de mot. Ces cellules annexes appliquent des données d'adresse prédéfinies en lieu et place des cellules du plan mémoire, afin d'éviter une programmation ligne par ligne des cellules du plan mémoire. Dans ce document, les cellules annexes sont des cellules de mémoire EEPROM transformées en mémoire ROM par suppression ou non de leur contact de ligne de bit.

Une telle mémoire EEPROM présente cependant des inconvénients. En effet, les cellules annexes occupent encore une surface non négligeable du substrat, ce qui accroît le coût de la mémoire EEPROM.

Il existe donc un besoin pour une mémoire non volatile comprenant :
- des lignes de bit et des lignes de mot donnant accès à des cellules mémoire électriquement effaçables et programmables d'un plan mémoire ;
- un décodeur de lignes de mot recevant une adresse d'entrée et destiné à appliquer un signal d'activation correspondant sur une ligne de mot ;
- un convertisseur présentant des entrées connectées aux lignes de mot, reproduisant sur des sorties le signal d'activation de chacune de ces entrées en abaissant son niveau de tension ;
- un circuit d'encodage comprenant des transistors dont le seuil de commutation est inférieur au niveau de tension du signal d'activation de sortie, ces transistors étant connectés de façon à générer une adresse de sortie, cette adresse de sortie étant spécifique à une ligne de mot activée si cette ligne de mot est la seule activée ;
- un circuit de test générant un signal d'erreur si l'adresse d'entrée diffère de l'adresse de sortie.

Selon une variante, la mémoire est du type EEPROM et le convertisseur est une adaptation d'un circuit de fermeture disposé en bordure du plan mémoire.

Selon encore une variante, le convertisseur comprend :
- une ligne de test dont le niveau de tension est inférieur au niveau de tension des signaux d'activation ;
- un transistor pour chaque ligne de mot, dont l'électrode de commande est connectée à une ligne de mot associée, dont une autre électrode est connectée à la ligne de test, et dont encore une autre électrode forme une desdites sorties du convertisseur.

Selon une autre variante, le circuit d'encodage comprend :
- d'autres transistors dont le seuil de commutation est inférieur au niveau de tension du signal d'activation de sortie, ces transistors étant connectés de façon à générer le complément de ladite adresse de sortie, ce complément de l'adresse de sortie étant spécifique à une ligne de mot activée si cette ligne de mot est la seule activée ;
- une première fonction ET entre les bits de même poids des adresses des lignes de mot activées simultanément ;
- une seconde fonction ET entre les bits de même poids des compléments des adresses des lignes de mot activées simultanément ;
- un comparateur entre les bits de même poids issus des première et seconde fonctions ET ;
- le circuit de test générant un signal d'erreur si le comparateur détermine deux bits identiques de même poids.

On peut également envisager que le circuit de test génère un signal d'erreur représentatif de l'activation simultanée de plusieurs lignes de mot lorsque lesdits deux bits identiques de même poids sont à 0.

On peut en outre envisager que le circuit de test génère un signal d'erreur représentatif de l'absence d'activation d'une ligne de mot lorsque lesdits deux bits identiques de même poids sont à 1.

Selon une variante, pour chaque transistor de génération d'adresse ou de génération de complément d'adresse, la grille est connectée à une sortie respective du convertisseur, une première électrode est connectée à un circuit de précharge associé à un bit d'adresse ou de complément d'adresse, une seconde électrode est connectée à une entrée du comparateur.

Selon encore une variante, la mémoire comprend un multiplexeur temporel de la connexion entre les sorties du convertisseur et les transistors de génération d'adresse, de sorte que les transistors de génération d'adresse génèrent séquentiellement une partie de l'adresse spécifique à la ligne activée.

Selon une autre variante, la mémoire comprend un multiplexeur temporel de la connexion entre les sorties du convertisseur et les transistors de génération du complément d'adresse, de sorte que les transistors de génération du complément d'adresse génèrent séquentiellement une partie du complément de l'adresse spécifique à la ligne activée.

L'invention sera mieux comprise à la lecture de la description qui suit, accompagnée des dessins annexés qui représentent :
- Figure 1, une paire de cellules mémoire d'un exemple de mémoire EEPROM ;
- Figure 2, un plan mémoire d'une telle mémoire EEPROM ainsi que ses décodeurs ;
- Figure 3, un plan mémoire et des circuits de fermeture disposés en bordure de ce plan selon l'art antérieur ;
- Figure 4, un plan mémoire et les circuits de fermeture de la figure 3 transformés en convertisseur basse tension selon l'invention ;
- Figure 5, une représentation schématique d'une mémoire EEPROM selon l'invention ;
- Figure 6, un détail des connexions d'un transistor de décodage ;
- Figure 7, une représentation schématique d'un circuit permettant un multiplexage temporel de portions d'adresses.

L'invention propose d'appliquer une adresse d'une ligne de mot à tester sur un décodeur. La mémoire non volatile dispose d'un convertisseur dont les entrées sont connectées aux lignes de mot de la mémoire non volatile. Le convertisseur reproduit sur chaque sortie le signal d'activation d'une entrée correspondante, en abaissant son niveau de tension. Les sorties sont connectées à des transistors à seuil de commutation réduit d'un circuit d'encodage. Les transistors à seuil réduit sont de type « basse tension » et présentent donc des dimensions réduites. Ces transistors génèrent alors une adresse de sortie. Cette adresse de sortie est comparée à l'adresse d'entrée. Un signal d'erreur est généré lorsque ces deux adresses diffèrent.

Ainsi, le test se passe avantageusement d'étape de programmation des cellules mémoire et les circuits nécessaires pour réaliser le test n'occupe qu'une surface très réduite du substrat.

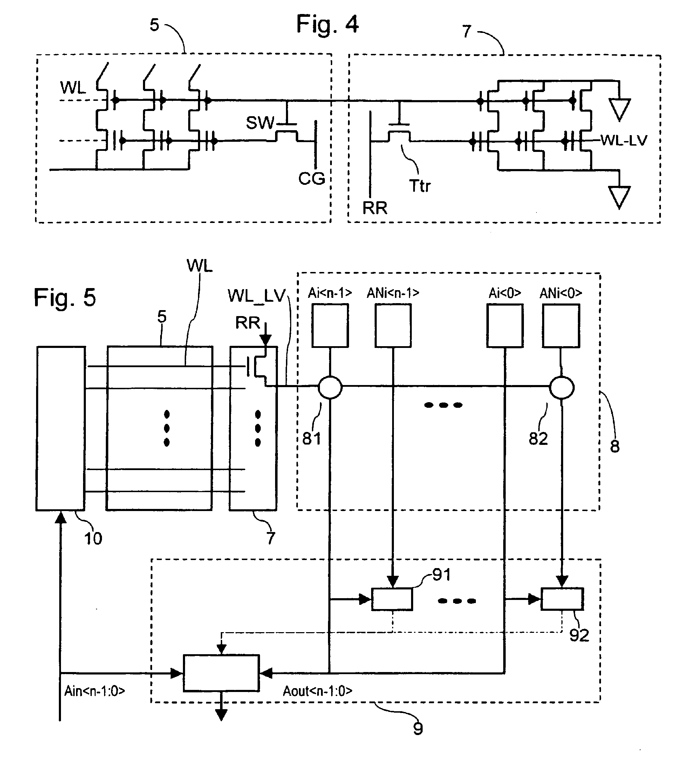

La figure 4 donne un exemple de convertisseur utilisé selon l'invention. Une mémoire EEPROM présente un plan mémoire 5 et un convertisseur d'une haute tension vers une basse tension 7. De façon connue en soi, des lignes de bit et des lignes de mot donnent accès à des cellules mémoire électriquement effaçables et programmables du plan mémoire. Chaque ligne de mot du plan mémoire 5 est connectée à une entrée respective du convertisseur 7. Le convertisseur 7 est réalisé par adaptation de transistors de fermeture habituellement réalisés en bordure de plan mémoire.

Un transistor de transformation Ttr est connecté à une entrée du convertisseur, et donc à une ligne de mot du plan mémoire. La ligne de mot WL illustrée est connectée à la grille du transistor Nmos de transformation Ttr. Un signal RR est appliqué sur le drain du transistor Ttr par une ligne de test. La source du transistor Ttr est connectée à une ligne de sortie basse tension WL_LV.

Le signal RR est un signal de test, activant le convertisseur de tension 7. Le signal RR présente un niveau de tension Vdd nettement inférieur au niveau de tension du signal d'activation appliqué sur la grille du transistor Ttr par la ligne WL. Le signal RR est par exemple au niveau basse tension de la mémoire (par exemple de l'ordre de 1.8 V). Lorsqu'un signal d'activation est appliqué sur la grille d'un transistor Ttr, ce transistor est rendu passant. La tension du signal RR est donc reproduite sur la source du transistor Ttr, et donc sur la ligne WL_LV. La ligne WL_LV reproduit ainsi l'état du signal de la ligne WL avec un niveau de tension réduit. Le signal RR est à Vss en dehors des phases de test.

La figure 5 représente schématiquement la mémoire selon l'invention. L'utilisation du niveau de tension réduit de la ligne WL_LV permet d'utiliser des transistors de génération d'adresse présentant un seuil de commutation plus faible et une surface minimum, ce qui permet de réaliser un circuit d'encodage occupant une surface de substrat réduite. La mémoire présente un circuit d'encodage 8 connecté aux sorties du convertisseur 7. Ce circuit d'encodage 8 est ainsi muni de transistors de génération d'adresse dont le seuil de commutation est inférieur au niveau de tension du signal d'activation de la ligne WL_LV. Ces transistors présentent une connexion générant une adresse de sortie spécifique à une ligne de mot si cette ligne de mot est la seule activée.

Dans l'exemple de la figure 5, l'adresse de sortie associée à une ligne de mot est générée par des transistors de génération d'adresse (transistors de décharge) associés à des circuits d'excursion haute de précharge. Chaque circuit de précharge est associé à un bit de l'adresse de sortie à générer : le circuit Ai<n-1> est ainsi associé au bit n-1, le circuit Ai<n-2> est associé au bit n-2, etc... Une combinaison unique des connexions d'une ligne WL_LV avec les circuits de précharge Ai<n-1> à Ai<0> au moyen des transistors de génération d'adresse définit ainsi l'adresse de sortie. Chaque circuit de précharge est par exemple constitué d'une résistance connectée à Vdd ou d'un transistor P-Mos chargé cycliquement.

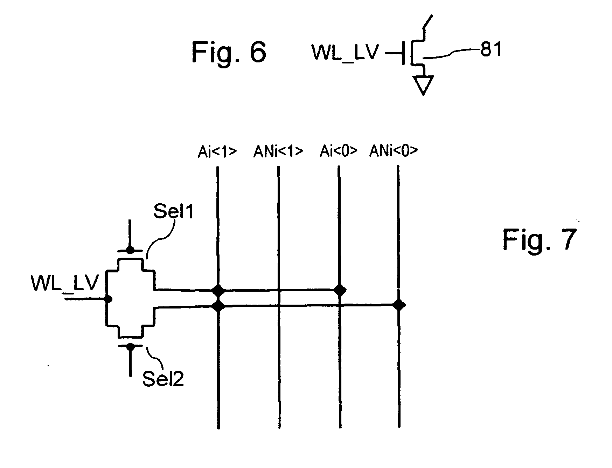

La figure 6 illustre les connexions d'un transistor de décharge 81 utilisé pour la génération d'adresse : sa grille est connectée à la ligne WL_LV, sa source est connectée à la masse et son drain est connecté un circuit de précharge Ai. La source du transistor 82 est destinée à la lecture de la valeur du bit Ai. Les transistors de décharge sont de préférence du type N-Mos, afin de réduire le temps de décharge.

Une connexion d'une ligne WL_LV à un transistor de génération d'adresse correspond à une valeur de 0 du bit associé. Une non connexion d'une ligne WL_LV à un transistor de génération d'adresse correspond à une valeur de 1 du bit associé.

Dans l'exemple de la figure 5, on a représenté les connexions d'une seule ligne de mot WL. La source du transistor de conversion Ttr est connectée à la grille du transistor 81. Le drain du transistor 81 est connecté au circuit de précharge Ai<n-1>. Cette connexion code donc un bit à 0 de cette ligne de mot. Par contre, aucun transistor de décharge ne connecte la source du transistor Ttr au circuit de précharge Ai<0>. Cette absence de connexion code donc un bit à 1 de cette ligne de mot.

Le fonctionnement pour tester l'adressage de la mémoire est le suivant : une adresse Ain<n-1 :0> est appliquée à l'entrée d'un décodeur d'adresse 10. Le décodeur applique alors (en l'absence de dysfonctionnement) un signal d'activation sur la ligne de mot correspondante. Cette ligne de mot est activée et le but d'un premier test est de vérifier que cette ligne correspond effectivement à l'adresse d'entrée. Les transistors de génération d'adresse correspondants génèrent l'adresse de sortie associée à la ligne de mot activée. Le signal d'activation rend passant les transistors codant un bit à 0. Ces transistors déchargent alors les noeuds Ai associés et un niveau logique 0 est alors lu pour ces bits. Les noeuds Ai non connectés à ces transistors restent chargés et un niveau logique 1 est alors lu pour ces bits. L'adresse de sortie Aout<n-1 :0> ainsi générée est alors lue par un circuit de test 9. Le circuit de test 9 génère un signal d'erreur si l'adresse d'entrée diffère de l'adresse de sortie. L'adresse d'entrée et l'adresse de sortie peuvent par exemple être appliquées sur les entrées d'une porte OU-EX dont on observe le signal de sortie.

Une ligne de mot non activée n'a pas d'incidence sur le circuit d'encodage : cette ligne de mot ne rend pas passant le transistor de conversion associé et ne peut donc pas rendre passant ses transistors de décharge.

On peut également noter que dans un grand nombre de cas, l'adresse de sortie ne correspondra pas à l'adresse d'entrée si aucune ou plusieurs lignes de mot sont activées simultanément.

L'invention permet également de déterminer d'autres types d'erreurs qu'une erreur de codage d'adresse.

Dans l'exemple de la figure 5, le circuit d'encodage comprend en outre des transistors connectés pour générer le complément de l'adresse de sortie. Le complément généré est également spécifique à une ligne de mot activée si cette ligne de mot est la seule activée.

Ces transistors présentent de préférence les mêmes caractéristiques que les transistors de génération d'adresse. Le complément de l'adresse de sortie est généré par une combinaison unique des connexions d'une ligne WL_LV avec des circuits de précharge ANi<n-1> à ANi<0> au moyen des transistors de génération du complément d'adresse. Chacun des circuits de précharge est associé à un bit du complément de l'adresse à générer. Une connexion d'une ligne WL_LV à un transistor de génération de complément correspond à une valeur de 0 du bit associé, une non connexion correspond à une valeur de 1 du bit associé. Une ligne WL_LV connectée à un circuit de précharge Ai<j> n'est pas connectée à un circuit de précharge Ani<j> et vice-versa.

Dans l'exemple, le transistor de décharge 82 est associé au circuit de précharge ANi<0>.

Les transistors de décharge des différentes lignes WL_LV et connectées à un même circuit de précharge Ai sont connectés en parallèle. De même les transistors connectés à un même circuit de précharge Ani sont connectés en parallèle. Si des adresses sont générées pour différentes lignes de mot activées simultanément, une telle connexion fournit une fonction ET entre leurs bits de même poids. De même, une telle connexion fournit une fonction ET entre les bits de même poids des différents compléments d'adresse générés. En effet, si plusieurs lignes de mot sont activées simultanément, il suffit que l'une d'elles rende passant un transistor de décharge pour forcer l'état du bit correspondant à 0.

Les bits de même poids de l'adresse de sortie et du complément d'adresse sont alors soumis à des comparateurs. Dans l'exemple, les bits n-1 sont soumis au comparateur 91 et les bits 0 sont soumis au comparateur 92. Les comparateurs sont par exemple constitués de portes OU-EX.

Ainsi, si et seulement si une seule ligne de mot est activée, aucun comparateur ne détermine des bits de même poids ayant des valeurs identiques.

Si un comparateur détermine deux bits de même poids identiques, deux cas se présentent :
- si ces bits sont identiques et valent 0, cela signifie que plusieurs lignes de mot sont activées simultanément : chaque ligne de mot ayant une adresse distincte, une ligne de mot génère un 0 pour au moins un bit d'adresse tandis qu'une autre ligne de mot génère un 0 pour le bit de même poids du complément d'adresse ;
- si ces bits sont identiques et valent 1, cela signifie qu'aucune ligne de mot n'est activée : aucune ligne de mot n'étant activée, aucun transistor de décharge n'est rendu passant. Par conséquent, le comparateur ne lit que des états logiques 1.

Le circuit de test peut générer un signal d'erreur adapté à chacun de ces cas. Il suffit pour cela de mesurer la valeur des bits de même poids identiques appliqués sur un comparateur.

Les signaux d'erreur générés peuvent soit être transmis à un dispositif d'autotest intégré dans la mémoire, soit à une machine de test extérieure à la mémoire.

Bien que l'invention ait été présentée auparavant avec une logique liée à l'utilisation de fonctions ET, on pourrait également envisager d'utiliser des fonctions OU entre les bits de même poids des adresses de lignes de mot activées simultanément.

La figure 7 illustre une variante de l'invention permettant de réduire le nombre de circuits de précharge et de transistors de décharge utilisés. Pour cela on réalise un multiplexage temporel des connexions entre les sorties du convertisseur et les transistors de génération d'adresse ou de complément d'adresse. On génère alors séquentiellement chaque partie de l'adresse ou du complément d'adresse.

La figure 7 illustre un exemple de multiplexage temporel simplifié. L'activation de la ligne WL_LV est prévue pour générer l'adresse <0 0 0 1>. Le transistor Sel2 est bloqué et le transistor Sel1 est dans un premier temps rendu passant pour connecter la ligne WL_LV aux transistors de décharge des noeuds Ai<1> et Ai<0>. Le circuit de test récupère ainsi dans un premier temps les bits <0 0> de la première partie de l'adresse. Le transistor Sel1 est ensuite bloqué et le transistor Sel2 est rendu passant pour connecter la ligne WL_LV aux transistors de décharge des noeuds Ai<1> et Ani<0>. Le circuit de test récupère alors les bits <0 1> de la seconde partie de l'adresse de la ligne de mot activée.

Un même circuit de précharge et un même transistor de décharge peuvent ainsi être utilisés pour coder plusieurs bits d'une adresse ou d'un complément d'adresse généré. On obtient ainsi un gain en surface de substrat important. Pour un rapport de surface élevé entre une cellule EEPROM et un transistor basse tension, un espace dans la hauteur du plan mémoire permet d'intégrer les transistors de multiplexage sans accroissement de la surface de silicium.

## Revendications

1. Mémoire non volatile comprenant :
- des lignes de bit et des lignes de mot donnant accès à des cellules mémoire électriquement effaçables et programmables d'un plan mémoire (5) ;
- un décodeur de lignes de mot (10) recevant une adresse d'entrée (Ain<n-1 :0>) et destiné à appliquer un signal d'activation correspondant sur une ligne de mot (WL) ;
**caractérisée en ce qu'**elle comprend en outre :
- un convertisseur (7) présentant des entrées connectées aux lignes de mot, reproduisant sur des sorties (WL_LV) le signal d'activation de chacune de ces entrées en abaissant son niveau de tension ;
- un circuit d'encodage (8) comprenant des transistors (81) dont le seuil de commutation est inférieur au niveau de tension du signal d'activation de sortie dudit convertisseur, ces transistors étant connectés de façon à générer une adresse de sortie (Aout<n-1 :0>), cette adresse de sortie étant spécifique à une ligne de mot activée si cette ligne de mot est la seule activée ;
- un circuit de test (9) générant un signal d'erreur si l'adresse d'entrée diffère de l'adresse de sortie.

2. Mémoire selon la revendication 1, **caractérisée en ce que :**
- la mémoire est du type EEPROM ;
- le convertisseur (7) est une adaptation d'un circuit de fermeture disposé en bordure du plan mémoire.

3. Mémoire selon la revendication 2, **caractérisée en ce que** le convertisseur comprend :
- une ligne de test (RR) dont le niveau de tension est inférieur au niveau de tension des signaux d'activation ;
- un transistor pour chaque ligne de mot, dont l'électrode de commande est connectée à une ligne de mot associée, dont une autre électrode est connectée à la ligne de test, et dont encore une autre électrode forme une desdites sorties du convertisseur.

4. Mémoire selon l'une quelconque des revendications précédentes, **caractérisée en ce que :**
- le circuit d'encodage (8) comprend :
- d'autres transistors (82) dont le seuil de commutation est inférieur au niveau de tension du signal d'activation de sortie, ces transistors étant connectés de façon à générer le complément de ladite adresse de sortie, ce complément de l'adresse de sortie étant spécifique à une ligne de mot activée si cette ligne de mot est la seule activée ;
- une première fonction ET entre les bits de même poids des adresses des lignes de mot activées simultanément ;
- une seconde fonction ET entre les bits de même poids des compléments des adresses des lignes de mot activées simultanément ;
- un comparateur (91, 92) entre les bits de même poids issus des première et seconde fonctions ET ;
- le circuit de test (9) générant un signal d'erreur si le comparateur détermine deux bits identiques de même poids.

5. Mémoire selon la revendication 4, **caractérisée en ce que** le circuit de test (9) génère un signal d'erreur représentatif de l'activation simultanée de plusieurs lignes de mot lorsque lesdits deux bits identiques de même poids sont à 0.

6. Mémoire selon la revendication 4 ou 5, **caractérisée en ce que** le circuit de test génère un signal d'erreur représentatif de l'absence d'activation d'une ligne de mot lorsque lesdits deux bits identiques de même poids sont à 1.

7. Mémoire selon l'une quelconque des revendications 4 à 6, **caractérisée en ce que** pour chaque transistor (81, 82) de génération d'adresse ou de génération de complément d'adresse, la grille est connectée à une sortie respective (WL_LV) du convertisseur, une première électrode est connectée à un circuit de précharge (Ai<j>, Ani<j>) associé à un bit d'adresse ou de complément d'adresse, une seconde électrode est connectée à une entrée du comparateur.

8. Mémoire selon l'une quelconque des revendications précédentes, **caractérisée en ce qu'**elle comprend un multiplexeur temporel de la connexion entre les sorties du convertisseur et les transistors de génération d'adresse, de sorte que les transistors de génération d'adresse génèrent séquentiellement une partie de l'adresse spécifique à la ligne activée.

9. Mémoire selon les revendications 4 et 8, **caractérisée en ce qu'**elle comprend un multiplexeur temporel de la connexion entre les sorties du convertisseur et les transistors de génération du complément d'adresse, de sorte que les transistors de génération du complément d'adresse génèrent séquentiellement une partie du complément de l'adresse spécifique à la ligne activée.

## Claims

1. Non-volatile memory that includes:
- bit lines and word lines providing access to electrically erasable and programmable memory cells of a memory plane (5);
- a word-line decoder (10) receiving an input address (Ain<n-1:0>) and intended to apply a corresponding activation signal to a word line (WL);
**characterised in that** it also includes:
- a converter (7) with inputs connected to the word lines, reproducing on outputs (WL_LV) the activation signal of each of these inputs by lowering its voltage level;
- an encoding circuit (8) that includes transistors (81) whose switching threshold is lower than the voltage level of the output activation signal of the said converter, these transistors being connected so as to generate an output address (Aout<n-1 :0>), where this output address is specific to an activated word line if this word line is the only one activated;
- a test circuit (9) generating an error signal if the input address differs from the output address.

2. Memory according to claim 1, **characterised in that:**
- the memory is of the EEPROM type;
- the converter (7) is an adaptation of a closure circuit located at the edge of the memory plane.

3. Memory according to claim 2, **characterised in that** the converter includes:
- a test line (RR) whose voltage level is lower than the voltage level of the activation signals;
- a transistor for each word line, whose control electrode is connected to an associated word line, of which another electrode is connected to the test line, and of which yet another electrode forms one of the said outputs of the converter.

4. Memory according to any of the previous claims, **characterised in that:**
- the encoding circuit (8) includes:
- other transistors (82) whose switching threshold is lower than the voltage level of the output activation signal, these transistors being connected so as to generate the complement of the said output address, this output address complement being specific to an activated word line if this word line is the only one activated;
- a first AND function between the bits of the same significance of the addresses of the word lines activated simultaneously;
- a second AND function between the bits of the same significance of the complements of the addresses of the word lines activated simultaneously;
- a comparator (91, 92) between the bits of the same significance resulting from the first and second AND functions;
- the test circuit (9) generating an error signal if the comparator determines two identical bits of the same significance.

5. Memory according to claim 4, **characterised in that** the test circuit (9) generates an error signal representing the simultaneous activation of several word lines when the said two identical bits of the same significance are at 0.

6. Memory according to claim 4 or 5, **characterised in that** the test circuit generates an error signal representing the absence of activation of a word line when the said two identical bits of the same significance are at 1.

7. Memory according to any of claims 4 to 6, **characterised in that** for each transistor (81, 82) for address generation or for address complement generation, the gate is connected to a respective output (WL_LV) of the converter, a first electrode is connected to a precharge circuit (Ai<j>, Ani<j>) associated with an address bit or address complement bit, and a second electrode is connected to an input of the comparator.

8. Memory according to any of the previous claims, **characterised in that** it includes a time multiplexer of the connection between the outputs of the converter and the address generation transistors, so that the address generation transistors sequentially generate a part of the address specific to the line activated.

9. Memory according to claims 4 and 8, **characterised in that** it includes a time multiplexer of the connection between the outputs of the converter and the address complement generation transistors, so that the address complement generation transistors sequentially generate a part of the complement of the address specific to the line activated.

## Patentansprüche

1. Nicht flüchtiger Speicher, der Folgendes umfasst:
- Bitleitungen und Wortleitungen, die Zugriff auf elektrisch löschbare und programmierbare Speicherzellen einer Speicherebene (5) gewähren;
- einen Wortleitungsdecoder (10), der eine Eingangsadresse (Ain<n-1 :0>) empfängt und dazu bestimmt ist, ein entsprechendes Aktivierungssignal auf eine Wortleitung (WL) anzulegen;
**dadurch gekennzeichnet, dass** er ferner Folgendes umfasst:
- einen Wandler (7)., der Eingänge aufweist, die mit den Wortleitungen verbunden sind, und der das Signal zur Aktivierung von jedem dieser Eingänge durch Senkung seines Spannungspegels auf Ausgängen (WL_LV) wiedergibt;
- eine Codierschaltung (8), die Transistoren (81) umfasst, deren Schaltschwelle niedriger als der Spannungspegel des Ausgangsaktivierungssignals des Wandlers ist, wobei diese Transistoren derart verbunden sind, dass sie eine Ausgangsadresse (Aout<n-1 :0>) erzeugen, wobei diese Ausgangsadresse für eine aktivierte Wortleitung spezifisch ist, wenn diese Wortleitung die einzige aktivierte ist;
- eine Testschaltung (9), die ein Fehlersignal erzeugt, wenn die Eingangsadresse sich von der Ausgangsadresse unterscheidet.

2. Speicher nach Anspruch 1, **dadurch gekennzeichnet, dass:**
- der Speicher vom Typ EEPROM ist;
- der Wandler (7) eine Anpassung einer am Rand der Speicherebene angeordneten Schließschaltung ist.

3. Speicher nach Anspruch 2, **dadurch gekennzeichnet, dass** der Wandler Folgendes umfasst:
- eine Testleitung (RR), deren Spannungspegel niedriger als der Spannungspegel der Aktivierungssignale ist;
- einen Transistor für jede Wortleitung, dessen Steuerelektrode mit einer zugehörigen Wortleitung verbunden ist, von dem eine andere Elektrode mit der Testleitung verbunden ist und von dem noch eine andere Elektrode einen der Ausgänge des Wandlers bildet.

4. Speicher nach einem der vorhergehenden Ansprüche, **dadurch gekennzeichnet, dass:**
- die Codierschaltung (8) Folgendes umfasst:
- andere Transistoren (82), deren Schaltschwelle niedriger als der Spannungspegel des Ausgangsaktivierungssignals ist, wobei diese Transistoren derart verbunden sind, dass sie das Komplement der Ausgangsadresse erzeugen, wobei dieses Komplement der Ausgangsadresse für eine aktivierte Wortleitung spezifisch ist, wenn diese Wortleitung die einzige aktivierte ist;
- eine erste UND-Funktion zwischen den gleichwertigen Bits der Adressen der gleichzeitig aktivierten Wortleitungen;
- eine zweite UND-Funktion zwischen den gleichwertigen Bits der Komplemente der Adressen der gleichzeitig aktivierten Wortleitungen;
- einen Komparator (91, 92) zwischen den gleichwertigen Bits, die aus der ersten und der zweiten UND-Funktion hervorgehen;
- wobei die Testleitung (9) ein Fehlersignal erzeugt, wenn der Komparator zwei identische gleichwertige Bits bestimmt.

5. Speicher nach Anspruch 4, **dadurch gekennzeichnet, dass** die Testschaltung (9) ein Fehlersignal erzeugt, das für die gleichzeitige Aktivierung mehrerer Wortleitungen charakteristisch ist, wenn die zwei identischen gleichwertigen Bits 0 sind.

6. Speicher nach Anspruch 4 oder 5, **dadurch gekennzeichnet, dass** die Testschaltung ein Fehlersignal erzeugt, das für das Nichtvorhandensein der Aktivierung einer Wortleitung charakteristisch ist, wenn die zwei identischen gleichwertigen Bits 1 sind.

7. Speicher nach einem der Ansprüche 4 bis 6, **dadurch gekennzeichnet, dass** das Gate für jeden Adresserzeugungs- (81, 82) oder Adresskomplementerzeugungs-Transistor mit einem entsprechenden Ausgang (WL_LV) des Wandlers verbunden ist, eine erste Elektrode mit einer Vorladeschaltung (Ai<j>, Ani<j>) verbunden ist, die einem Adress- oder Adresskomplementbit zugehörig ist, und eine zweite Elektrode mit einem Eingang des Komparators verbunden ist.

8. Speicher nach einem der vorhergehenden Ansprüche, **dadurch gekennzeichnet, dass** er einen Zeitmultiplexer der Verbindung zwischen den Ausgängen des Wandlers und den Adresserzeugungstransistoren umfasst, derart, dass die Adresserzeugungstransistoren sequentiell einen Abschnitt der Adresse erzeugen, der für die aktivierte Leitung spezifisch ist.

9. Verfahren nach Anspruch 4 und 8, **dadurch gekennzeichnet, dass** er einen Zeitmultiplexer der Verbindung zwischen den Ausgängen des Wandlers und den Adresskomplementerzeugungs-Transistoren umfasst, derart, dass die Adresskomplement-Erzeugungstransistoren sequentiell einen Abschnitt des Komplements der Adresse erzeugen, der für die aktivierte Leitung spezifisch ist.
